Europäisches Patentamt

European Patent Office

Office européen des brevets

(11) Publication number: **0 352 830**
**A1**

## EUROPEAN PATENT APPLICATION

(21) Application number: **89201523.1**

(22) Date of filing: **13.06.89**

(51) Int. Cl.⁴: **H01L 27/115**

(30) Priority: **29.07.88 IT 2156088**

(43) Date of publication of application:
**31.01.90 Bulletin 90/05**

(84) Designated Contracting States:
**DE FR GB NL SE**

(71) Applicant: **SGS-THOMSON
MICROELECTRONICS s.r.l.
Via C. Olivetti, 2
I-20041 Agrate Brianza Milano(IT)**

(72) Inventor: **Mazzali, Stefano
Via Crema, 38
I-20135 Milano(IT)**

(74) Representative: **Mittler, Enrico et al
c/o Marchi & Mittler s.r.l. Viale Lombardia, 20
I-20131 Milano(IT)**

(54) **Tablecloth matrix of EPROM memory cells individually accessible by a traditional decoder.**

(57) The matrix comprises source lines (S) and drain lines (D) parallel and alternating with each other, floating gate areas (F) placed between said source lines (S) and drain lines (D), and control gate lines (G) parallel with each other and perpendicular to said source lines (S) and drain lines (D) and superimposed on said floating gate areas (F). Strips of field oxide (OC) divide the matrix in electrically insulated groups of cells (C) formed of two drain lines (D) and an interposed source line (S) connected by floating gate areas (F) with superimposed control gate lines (G).

Fig.1

EP 0 352 830 A1

## Tablecloth matrix of EPROM memory cells individually accessible by a traditional decoder

The present description relates to a tablecloth matrix of EPROM memory cells individually accessible by traditional decoding.

In manufacturing a memory matrix it is important to increase to the maximum the density of the cells to improve performance and better utilize the available area. This calls for the search for and use of ever more advanced technologies, especially in the photolithographic field, which is required to define ever smaller structures, even down to submicrometric dimensions such as 0.8 micron. Despite said technology it is ever more difficult to compact the cells so that research is now directed toward new structures which permit overcoming these problems.

In the case of EPROM cells a step forward was made several years ago in the realization of the so-called "tablecloth matrix" wherein two groups of source lines and one group of drain lines parallel and alternating with each other are crossed perpendicularly by mutually parallel control gate lines while floating gate areas are placed between said source and drain lines beneath said control gate lines.

The new configuration, better described in Italian patent application no. 23479 A/84 dated 7 November 1984 in the name of the same assignee proved advantageous as regards dimensional problems, reaching levels of miniaturization, cell density and compactness of considerable interest. The decoder required to accede to the individual cells proved however very complex since it was necessary to distinguish between the source lines of one group and the other in addition to directing the appropriate drain and control gate lines. This advised against practical use.

To overcome this drawback the original tablecloth configuration was subsequently modified into a so-called "semitablecloth" configuration wherein all the source lines are connected together electrically so that each cell in reality consists of two semicells written and read simultaneously.

With the semitablecloth configuration, better described in Italian patent application no. 19656 A/87 dated 12 March 1987 in the name of the same applicant, it proved possible to use a traditional decoder. To this was added the important advantage of offering a 100% redundancy, it being impossible that both semicells of a same cell prove defective. But this configuration has the defect of occupying much space.

In view of this state of the art the object of the present invention is to accomplish an EPROM memory cell matrix which would offer the virtues of size and compactness of the tablecloth matrix mentioned above, at the same time simplifying the access procedure in such a manner as to permit the use of a traditional decoder.

In accordance with the invention said object has been achieved with an EPROM memory cell matrix comprising mutually parallel and alternating source and drain lines, floating gate areas placed between said source and drain lines, and control gate lines parallel with each other and perpendicular to said source and drain lines superimposed on said floating gate areas characterized in that it comprises strips of field oxide parallel to said source and drain lines and alternating therewith beneath said gate control lines so as to divide the matrix in electrically isolated groups of cells formed by two drain lines and a source line placed between them connected by floating gate areas with superimposed control gate lines.

In this manner the 100% redundancy of the semitablecloth matrix is lost but the high cell density of the tablecloth matrix is saved and, above all, individual access to the individual cells is made possible with a completely traditional decoder.

The division in groups provided by the strips of field oxide makes possible safe selection of one cell at a time, giving voltage to the appropriate drain line and the appropriate control gate line and keeping all the source lines of the matrix grounded. The field oxide prevents the voltage applied to the selected drain line from involving other cells associated with the same gate control line and thus individualizes the access provided.

The characteristics and advantages of the present invention will be made evident by the following detailed description of a form of practical embodiment thereof illustrated as a nonlimiting example in the annexed drawings wherein -

FIG. 1 shows a schematic plan view of a portion of an EPROM Memory cell matrix in accordance with the present invention,

FIG. 2 shows an enlarged cross section along line II-II of FIG. 1 of a detail of said matrix,

FIG. 3 shows an enlarged cross section along line III-III of FIG. 1 of another detail of said matrix, and

FIG. 4 shows an enlarged cross section along line IV-IV of FIG. 1 of another detail of said matrix.

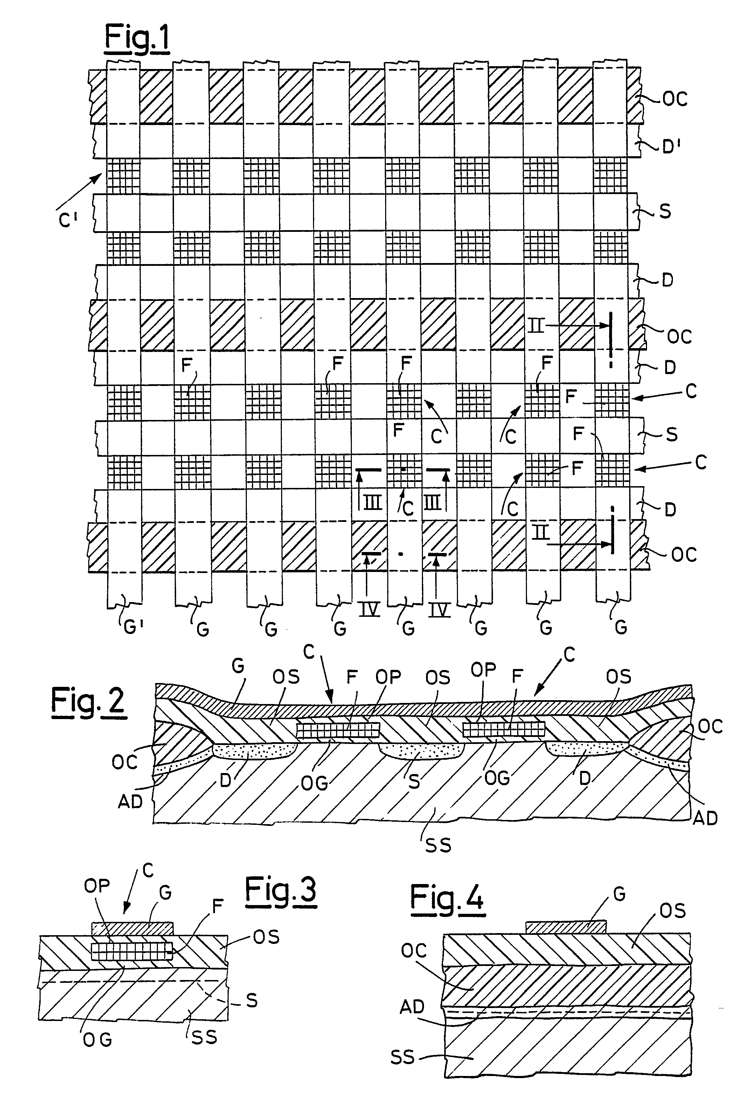

The matrix shown in the drawings, termed "tablecloth", comprises a substrate of single-crystal silicon SS on the top surface of which are made, by the diffusion of an appropriate dope, two pluralities of parallel source lines S and drain lines D alternating with each other (FIG. 1).

With the abovesaid source and drain lines there also alternate parallel strips of field oxide OC which divide them in parallel groups of two drain lines D and an interposed source line S. Under each strip of field oxide OC the substrate SS calls for a doped area AD (FIGS. 2 and 4) which has the purpose of raising the degree of electrical insulation already assured by the field oxide.

Between the source lines S and drain lines D of each group defined by the field oxide strip OC there are arranged parallel successions of floating gate areas F which, together with the above S and D lines and strips OC, are surmounted by control gate lines G parallel with each other and perpendicular to the source and drain lines. Thin oxide OG and OP is placed between the floating gate area F and the substrate SS and between the control gate lines G and the floating gate areas F (FIGS. 2 and 3). Thick oxide OS is in turn placed at the sides of the floating gate area F and under the control gate lines G (FIGS. 2, 3 and 4).

The matrix illustrated in the drawings allows individual access to the individual EPROM cells C. To this end it is sufficient to apply voltage to the drain line and control gate line of the selected cell while at the same time keeping all the source lines grounded. For example, to select the cell $C'$ voltage is applied to the drain line $D'$ and the control gate line $G'$.

As already mentioned the field oxide strips OC prevent the selected drain line from affecting cells other than the one desired. The doped areas AD raise the degree of insulation assured by the strips OC and hence the threshhold of the parasite transistors originated by the couplings between the control gate lines G and the substrate SS through the field oxide OC.

## Claims

1. EPROM memory cell tablecloth matrix comprising source lines (S) and drain lines (D) parallel and alternating with each other, floating gate areas (F) placed between said source lines (S) and drain lines (D) and control gate lines (G) parallel with each other and perpendicular to said source lines (S) and drain lines (D) superimposed on said floating gate areas (F) characterized in that it comprises field oxide strips (OC) parallel with said source lines (S) and drain lines (D) and alternating therewith under said control gate lines (G) so as to divide the matrix in electrically insulated groups of cells formed of two drain lines (D) and an interposed source line (S) connected by a floating gate area (F) with superimposed control gate lines (G).

2. Matrix in accordance with claim 1 characterized in that it comprises doped areas (AD) placed under said field oxide strips (OC).

Fig.1

Fig.2

Fig.3

Fig.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-4 663 645 (HITACHI LTD) <br> * Column 4, lines 38-41; figures 2,3 * <br> --- | 1,2 | H 01 L 27/115 |
| Y,D | FR-A-2 572 836 (SGS) <br> * Whole document * <br> ----- | 1,2 | |

TECHNICAL FIELDS SEARCHED (Int. Cl.5)

H 01 L 27/00
H 01 L 29/00
G 11 C 17/00

The present search report has been drawn up for all claims

| Place of search | Date of completion of the search | Examiner |
|---|---|---|
| THE HAGUE | 18-10-1989 | NILES N.P.E. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P0401)